# EUROPEAN PATENT APPLICATION

(11) **EP 1 950 811 A1**
(43) Date of publication of application: **30.07.2008**
(21) Application number: 06822696.8
(22) Date of filing: 31.10.2006
(51) Int. Cl.: H01L 31/04, H01L 31/10

(54) **PHOTOELECTRIC TRANSDUCER AND PROCESS FOR PRODUCING THE SAME**

(30) Priority: 31.10.2005 JP 2005316788
(71) Applicant: ROHM CO., LTD., Kyoto-shi, Kyoto 615-8585 (JP); National Institute of Advanced Industrial Science and Technology, Tokyo 100-8921 (JP)
(72) Inventor: TAKAOKA, Masaki, Kyoto 615-8585 (JP); MATSUSHIMA, Osamu, Kyoto 615-8585 (JP); ISHIZUKA, Shogo, Ibaraki 305-8568 (JP); NIKI, Shigeru, Ibaraki 305-8568 (JP); SAKURAI, Keiichiro, Ibaraki 305-8568 (JP)
(74) Representative: Steil, Christian
(86) International application number: PCT/JP2006/321767
(87) International publication number: WO 2007/052667

(57) **Abstract**

A photoelectric converter includes a lower electrode layer, a compound semiconductor thin film of a chalcopyrite structure functioning as a photoabsorption layer and a light transmitting electrode layer that are sequentially laminated on a substrate. An end portion of the of compound semiconductor thin film is positioned outward beyond an end of the light transmitting electrode layer.

## Description

### TECHNICAL FIELD

The present invention relates to a photoelectric converter and a method for producing the same, and more particularly, it relates to a photoelectric converter employing a semiconductor thin film having a chalcopyrite structure.

### BACKGROUND ART

A thin-film solar battery employing CuInSe₂ (CIS thin film) which is a semiconductor thin film with a chalcopyrite structure made of a group Ib element, a group IIIb element and a group VIb element or Cu(In, Ga)Se₂ (CIGS thin film) prepared by solid soluting Ga therein as a photoabsorption layer advantageously exhibits high energy conversion efficiency and has small deterioration of the efficiency resulting from photoirradiation or the like.

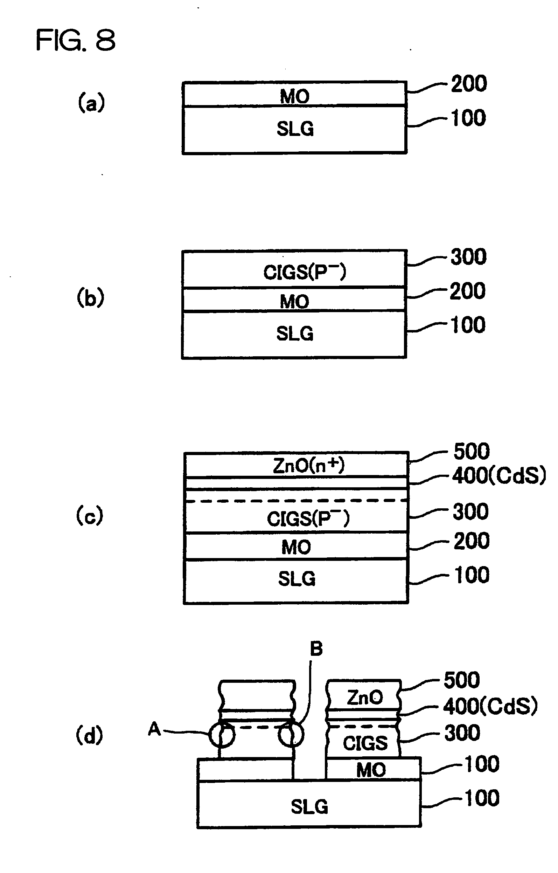

FIGS. 8(a) to 8(d) are sectional views of a device for illustrating a conventional method for producing cells of a CIGS thin-film solar battery.

As shown in FIG. 8(a), a Mo (molybdenum) electrode layer 200 for forming a plus-side lower electrode is first formed on an SLG (soda-lime glass) substrate 100.

Then, a photoabsorption layer 3 made of a CIGS thin film compositionally-controlled to exhibit a p⁻ type is formed on the Mo electrode layer 200, as shown in FIG. 8(b).

Then, a buffer layer 400 made of CdS is formed on the photoabsorption layer 3, and a light transmitting electrode layer 500 made of ZnO (zinc oxide), doped with an impurity to exhibit an n⁺ type, for forming a minus-side upper electrode is formed on the buffer layer 400, as shown in FIG. 8(c).

Then, the layers from the light transmitting electrode layer 500 made of ZnO up to the Mo electrode layer 200 are collectively scribed with a mechanical scriber, as shown in FIG. 8(d). Thus, the respective cells of the thin-film solar battery are electrically isolated from one another (in other words, the respective cells are indivuduated).

Laser scribing (scribing technique of partially removing a thin film by applying a laser beam) can also be utilized for this scribing step.

In this case, however, the laser beam is so concentrically applied that high heat is locally generated, whereby the characteristics of the cells are disadvantageously deteriorated.

Therefore, the cells of the solar battery are generally electrically isolated from one another with the mechanical scriber.

A mechanical scriber described in Patent Document 1 performs scribing by vertically pressing a blade tapered at a prescribed cone angle and having a flat tip against scribed portions of a workpiece with a prescribed pressure and moving the blade along the worked surface.
Patent Document 1: Japanese Unexamined Patent Publication No. 2004-115356

### DISCLOSURE OF THE INVENTION

### PROBLEMS TO BE SOLVED BY THE INVENTION

At present, a CIS thin film and a CIGS thin film are mainly utilized as a solar battery.

The inventors of this invention have noted the high optical absorption coefficient of this compound semiconductor thin film material and the characteristic of high sensitivity over a wide wavelength range from visible light to near infrared light, and conducted a study as to utilization of this compound semiconductor thin film as an image sensor for a security camera (camera sensing visible light by day and sensing near infrared light by night), a personal identification camera (camera for personal identification with near infrared light not influenced by external light) or an onboard camera (camera loaded on a vehicle for nightly visual aid or distant visual field assurance).

As a result, is it clarified that a dark current (current flowing in a P-N junction in reverse bias) is unexpectedly large in the case of the CIS thin film (CuInSe₂) for example.

In other words, a dark current of about 1 × 10⁻³ A/cm² flows in a reverse bias of -0.8 V, for example, and this value is greater than that of a silicon material by six orders of magnitude. If nothing is done, it leads to a consequence that weak light of less than 1000 Lux is hidden by noise and cannot be detected.

Therefore, the dark current must be remarkably reduced. The inventors have detailedly investigated the factor increasing the dark current in the compound semiconductor thin film. The result has confirmed that damages or defects are caused in the crystals of the compound semiconductor material in mechanical scribing thereby forming a plurality of energy levels on the interface of the P-N junction to cause a large dark current.

Referring to FIG. 8(d), ends (encircled portions A and B in the Figure of the interface (boundary between depletion layers: shown by a dotted line) of the P-N junction reach the sidewall of a CIGS thin film 300 exposed by mechanical scribing. The mechanically scribed surface has remarkable damages in the crystals, and includes unnecessary interfacial levels. Therefore, a leakage current of the P-N junction is increased on these portions.

The present invention has been proposed on the basis of this consideration, and an object thereof is to remarkably reduce a dark current in a photoelectric converter employing a compound semiconductor thin film.

### MEANS FOR SOLVING THE PROBLEMS

A photoelectric converter of the present invention includes a lower electrode layer on a substrate, a compound semiconductor thin film with a chalcopyrite structure functioning as a photoabsorption layer and a light transmitting electrode layer that are sequentially laminated, and a pattern of the light transmitting electrode layer is so formed that an end of the compound semiconductor thin film with the chalcopyrite structure is positioned outward beyond an end of the light transmitting electrode layer.

Dangling bonds or the like may be present on an end surface of the pattern of the compound semiconductor thin film to form unnecessary energy levels. According to this structure, however, the light transmitting electrode is removed that the end of a P-N junction interface formed on the interface between the compound semiconductor thin film and the light transmitting electrode does not function as an element region. Therefore, a dark current resulting from a leakage current can be reduced.

The photoelectric converter according to the present invention also includes an integration of a plurality of photoelectric conversion element cells.

According to this structure, the dark current can be reduced also in a photoelectric converter having an integrated structure.

The photoelectric converter according to the present invention includes an integration of a plurality of photoelectric conversion element cells and the compound semiconductor thin film with the chalcopyrite structure integrally formed on the surface of the substrate.

According to this structure, a photoelectric converter having a low dark current can be formed with excellent workability by simply patterning the light transmitting electrode.

The photoelectric converter according to the present invention includes an integration of a plurality of photoelectric conversion element cells and the compound semiconductor thin film with the chalcopyrite structure formed such that the pattern edge thereof is positioned outward beyond a pattern edge of the light transmitting electrode.

According to this structure, the dark current can be reduced also in the photoelectric converter having the integrated structure.

In the photoelectric converter according to the present invention, the compound semiconductor thin film is arranged such that a pattern width thereof is larger than the pattern of the light transmitting electrode.

According to this structure, a matrix-type photoelectric converter having reduced dark current can be easily formed. In formation of single photolithography, the photoelectric converter can be formed that the pattern edge of the compound semiconductor thin film with the chalcopyrite structure is positioned outward beyond the pattern edge of the light transmitting electrode by adjusting etching conditions.

In the photoelectric converter according to the present invention, the compound semiconductor thin film with the chalcopyrite structure is Cu(Inₓ,Ga₍₁₋ₓ₎)Se₂ (0 ≦ x ≦ 1).

According to this structure, the band gap of a CIS thin film (CuInSe₂) can be effectively widened by employing a CIGS thin film substituting gallium for part of In (indium) . Thus, the recombination process of carriers can be reduced by widening the bandwidth, and the dark current can be reduced.

In the photoelectric converter according to the present invention, the light transmitting electrode layer is configured with a non-doped ZnO film provided on the interface between the light transmitting electrode layer and the compound semiconductor thin film and an n⁺-type ZnO film provided on the non-doped ZnO film.

According to this structure, the non-doped ZnO film (i-ZnO) is provided as the light transmitting electrode layer to fill up voids and pinholes formed in the underlayer CIGS thin film with a semi-insulating layer and form an i-p junction with the CIGS thin film. Therefore, a leakage resulting from a tunnel current can be prevented that is caused when the conductive ZnO film (n⁺) is directly brought into contact with the CIGS thin film. Therefore, the dark current on the P-N junction interface can be reduced by increasing the thickness of the non-doped ZnO film (i-ZnO).

The photoelectric converter according to the present invention includes a photosensor having a sensitivity also in a near infrared region.

The sensor according to the present invention has a high sensitivity also for near infrared light, whereby the same is sufficiently utilizable as a security camera (camera sensing visible light by day and sensing near infrared light by night), a personal identification camera (camera for personal identification with near infrared light not influenced by external light) or an onboard camera (camera loaded on a vehicle for nightly visual aid or distant visual field assurance).

The photoelectric converter according to the present invention includes a solar battery.

In the photoelectric converter according to the present invention, photoelectric conversion loss on the interface of the P-N junction is sufficiently reduced as compared with the prior art. Therefore, a solar battery having a high collection efficiency for charges generated by light and high photoelectric conversion efficiency can be implemented.

The method according to the present invention is a method for producing a photoelectric converter configured by sequentially laminating a lower electrode layer, a compound semiconductor thin film with a chalcopyrite structure functioning as a photoabsorption layer and a light transmitting electrode layer on a substrate, and includes the step of selectively removing and patterning the light transmitting electrode with respect to the compound semiconductor thin film of the chalcopyrite structure to expose a part of the compound semiconductor thin film of the chalcopyrite structure.

In the method for producing a photoelectric converter according to the present invention, the step of patterning the light transmitting electrode layer is the step of patterning so as to position an end of the light transmitting electrode layer inward beyond a side surface of the compound semiconductor thin film such that an end of a P-N junction interface configured by contact between the light transmitting electrode layer and the compound semiconductor thin film does not reach the side surface of the compound semiconductor thin film.

In the method for producing a photoelectric converter according to the present invention, the step of forming the compound semiconductor thin film with the chalcopyrite structure includes the step of forming a Cu(Inₓ,Ga₍₁₋ₓ₎)Se₂ (0 ≦ x ≦ 1) thin film by PVD, and the step of forming the light transmitting electrode layer includes the steps of forming a non-doped ZnO film on the compound semiconductor thin film and forming an n⁺-type ZnO film on the non-doped ZnO film.

The light transmitting electrode layer is preferably patterned by photolithographic etching in place of mechanical scribing. Accordingly, the lower electrode layer and the compound semiconductor thin film with the chalcopyrite structure functioning as the photoabsorption layer are also patterned by photolithographic etching, similarly to that after film formation by PVD. Thus, neither damages nor defects are caused in the compound semiconductor thin film unlike that of mechanical scribing, and the dark current can be remarkably reduced. The PVD herein denotes a method of forming a film by depositing a raw material evaporated in a vacuum.

Patterning using photolithography can prevent generation of damages and defects in the crystals of the compound semiconductor unlike the case of employing mechanical scribing. Therefore, no unnecessary energy levels are formed on the interface of the P-N junction, and the dark current can be reduced. Further, the leakage current from the end of the P-N junction interface can also be prevented by innovating the pattern of the ZnO film and filling up the P-N junction interface. In other words, the dark current can be improved on the order of 10³ by changing the production process and optimizing the device structures of the photoabsorption layer and the light transmitting electrode layer. In addition, the dark current can be reduced on the order of 10² by band gap control in Cu(Inₓ, Ga₍₁₋ₓ₎)Se₂.

### EFFECT OF THE INVENTION

According to the present invention, the leakage current from the end of the interface of the P-N junction can be further reduced by patterning the light transmitting electrode layer so that the position of the end thereof is inward beyond the side surface of the compound semiconductor thin film and the end of the P-N junction interface does not reach the side surface of the patterned compound semiconductor thin film (in other words, the P-N junction interface is embedded in the compound semiconductor thin film).

Further, the recombination process of carriers can be reduced by using the CIGS thin film substituting gallium for part of In (indium) to widen the bandwidth. As a result, the dark current can be further reduced.

In addition, the dark current can be reduced on the order of 10² by band gap control in Cu(Inₓ,Ga₍₁₋ₓ₎)Se₂.

The sensor according to the present invention has a high sensitivity also for near infrared light, whereby the same is sufficiently utilizable as a security camera (camera sensing visible light by day and sensing near infrared light by night), a personal identification camera (camera for personal identification with near infrared light not influenced by external light) or an onboard camera (camera loaded on a vehicle for nightly visual aid or distant visual field assurance).

In the photoelectric converter according to the present invention, photoelectric conversion loss on the interface of the P-N junction is sufficiently reduced as compared with the prior art. Therefore, a solar battery having a high collection efficiency for charges generated by light and high photoelectric conversion efficiency can be implemented.

The foregoing and other objects, features and effects of the present invention will become more apparent from the following detailed description of the embodiments with reference to the attached drawings.

### BRIEF DESCRIPTION OF THE DRAWINGS

[FIG. 1] A flow chart showing an outline of principal steps of a method for producing a photoelectric converter according to the present invention.
[FIG. 2] (a) to (j) are sectional views of a device along the principal steps for specifically illustrating the method for producing a photoelectric converter according to the present invention.
[FIG. 3] Diagrams schematically showing SEM (scanning electron microscope) photographs of the device for illustrating a method of patterning a CIGS thin film: (a) shows a state immediately after dry etching of the CIGS thin film; and (b) shows a state after wet etching.
[FIG. 4] A diagram schematically showing a SEM (scanning electron microscope) sectional photograph of the device after patterning of a light transmitting electrode layer (ZnO film).
[FIG. 5] A diagram showing absorption coefficients of a CIS thin film (CIGS thin film) with respect to the wavelengths of light.
[FIG. 6] A schematic sectional view of a CMOS image sensor formed on a silicon substrate.
[FIG. 7] A schematic sectional view of a composite image sensor according to the present invention formed by laminating a photoelectric converter (photosensor) made of a compound semiconductor thin film on a silicon substrate including a CMOS circuit.
[FIG. 8] (a) to (d) are sectional views of a device for illustrating a conventional method for producing a CIGS thin-film solar battery.

### DESCRIPTION OF THE REFERENCE CHARACTERS

10 soda-lime glass (SLG)
20 Mo (molybdenum) film
30 CIGS thin film as photoabsorption layer
35 residue after dry etching
40 resist pattern for etching CIGS thin film
50 CdS film as buffer layer
60 ZnO film (i-ZnO, n-ZnO)
70 mask (resist pattern) for etching ZnO film
80 P-N junction interface (boundary between depletion layers)
85, 90 extraction electrode of photoelectric converter

### BEST MODE FOR CARRYING OUT THE INVENTION

Embodiments of the present invention are now described with reference to the drawings.

### (Embodiment 1)

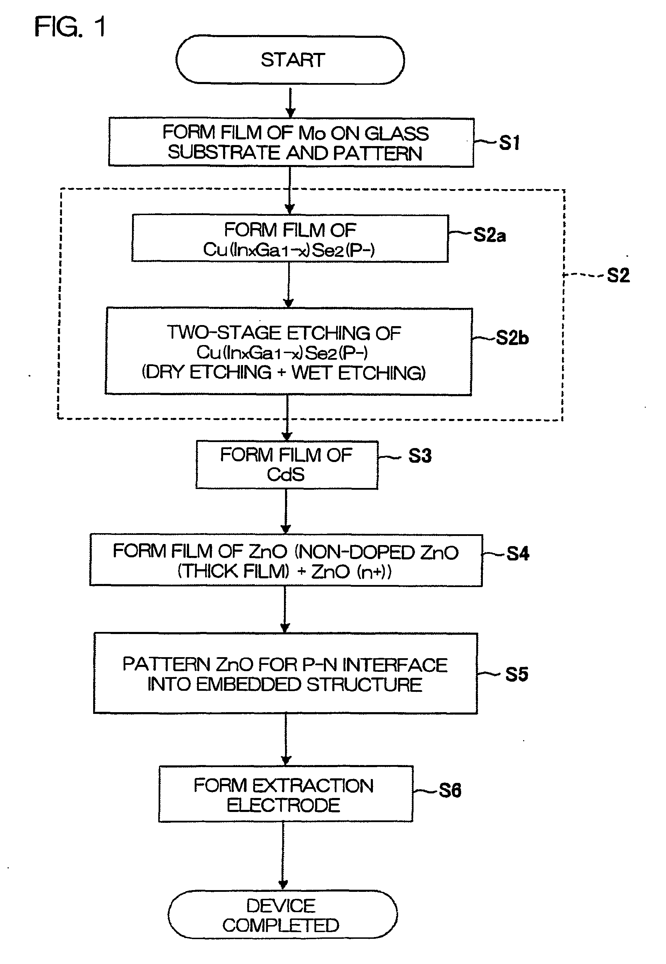

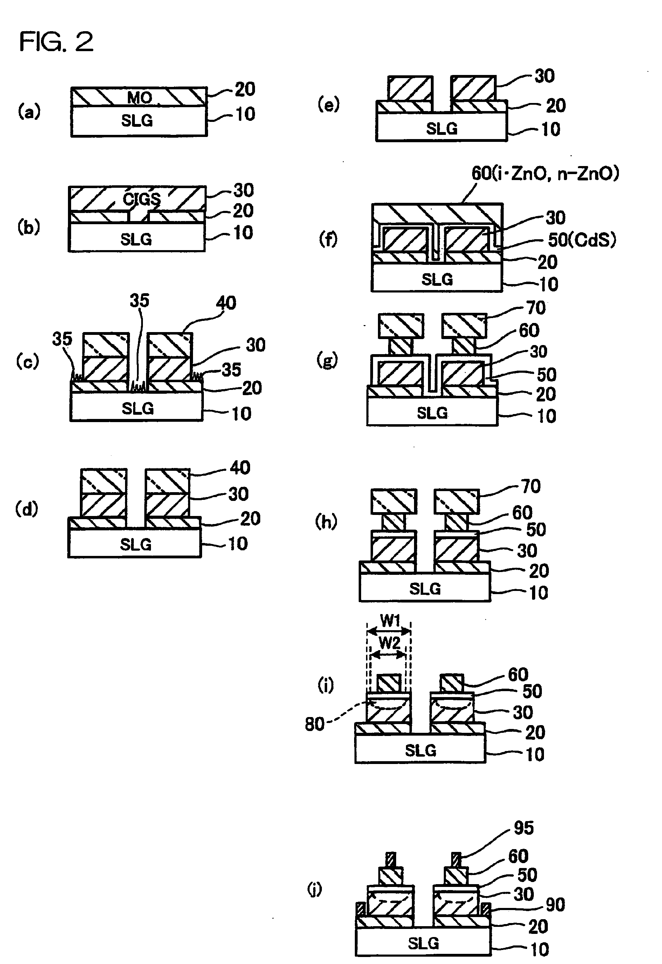

FIG. 1 is a flow chart showing an outline of principal steps of a method for producing a photoelectric converter according to the present invention. FIGS. 2 (a) to 2(j) are step sectional views.

As shown in FIG. 2 (j), the photoelectric converter according to the present invention is configured by sequentially laminating a lower electrode layer 20 made of a Mo thin film, a p-type semiconductor thin film (Cu(Inₓ,Ga₍₁₋ₓ₎)Se₂ (0 ≦ x ≦ 1)) 30 with a chalcopyrite structure functioning as a photoabsorption (photoelectric conversion) layer and a light transmitting electrode layer on a substrate 10, the pattern of the light transmitting electrode layer is formed that an end of the compound semiconductor thin film with the chalcopyrite structure is positioned outward beyond an end of the light transmitting electrode layer, and the light transmitting electrode layer is made of a non-doped ZnO film 50 provided on the interface between the same and the compound semiconductor thin film and an n⁺-type ZnO film 60 provided on the non-doped ZnO film.

According to this structure, the non-doped ZnO film (i-ZnO) is formed to fill up voids and pinholes formed in the underlayer CIGS thin film with a semi-insulating layer and form an i-p junction with the CIGS thin film. Thus, a leakage resulting from a tunnel current caused when the conductive ZnO film (n⁺) is directly brought into contact with the CIGS thin film can be prevented. Therefore, a dark current on a P-N junction interface can be reduced by increasing the thickness of the non-doped ZnO film (i-ZnO).

In the method for producing a photoelectric converter according to the present invention, the laminated lower electrode layer, p-type compound semiconductor thin film (hereinafter referred to as the CIGS thin film) of the chalcopyrite structure functioning as the photoabsorption layer and the light transmitting electrode layer (including both of the non-doped portion and the portion doped with an impurity to exhibit the n⁺ type) are individually patterned by photolithography for minimizing damages to the crystals of the CIGS thin film.

In the method for producing a photoelectric converter according to the present invention, a Mo (molybdenum) layer for forming a lower electrode is formed by sputtering (about 0.6 µm) on a glass substrate, and thereafter patterned by photolithography (step S1).

Then, a CIGS thin film is formed and patterned by photolithography. In other words, a compositionally-controlled p⁻-type CIGS thin film (Cu(Inₓ, Ga₍₁₋ₓ₎)Se₂ (0 < x < 1)) is formed by ion beam sputtering, for example (step S2). The thickness of this film is about 1.7 µm.

Then, the CIGS thin film (p⁻) is patterned by two-stage etching employing both dry etching and wet etching (step S3). Thus, an electrically isolated CIGS thin film (p⁻) is obtained.

Then, a thin CdS film (about 50 nm) serving as a buffer layer (window layer) is formed by solution growth (step S4).

Then, a ZnO film serving as a light transmitting electrode layer is formed (step S5). This step is the most important characteristic point of the present invention.

In other words, a non-doped ZnO film (i-ZnO) and a low-resistance ZnO (n⁺) film doped with an impurity are continuously formed by sputtering (step S5a). The i-ZnO film has a small thickness of about 60 nm, while the low-resistance ZnO (n⁺) film has a sufficient thickness of about 1 µm.

The non-doped ZnO film (i-ZnO) functions to fill up voids and pinholes formed in the underlayer CIGS thin film with a semi-insulating layer and form an i-p junction with the CIGS thin film, thereby preventing a leakage resulting from a tunnel current caused when the low-resistance ZnO (n⁺) film is directly brought into contact with the CIGS thin film.

Therefore, the dark current on the P-N junction interface can be reduced by increasing the thickness of the non-doped ZnO film (i-ZnO). (Results confirmed that the effect of reducing the dark current was about 1/5). However, since the increased thickness is sufficiently small (60 nm, for example), a substantial p-n junction is conceivably formed between the low-resistance ZnO (n⁺) film functioning as the light transmitting electrode layer and the CIGS thin film (p⁻).

Then, the ZnO film (i-ZnO and ZnO (n⁺)) is patterned (step S5b). In this step S5b, the ZnO film is patterned that the position of an end of the ZnO film is inward beyond the side surface of the patterned CIGS thin film (p⁻) (in other words, the ZnO film having a smaller lateral width than that of the CIGS thin film (p⁻) is formed on this CIGS thin film (p⁻) to form a pyramidal structure).

Thus, an end of the interface (boundary between depletion layers) of the P-N junction formed by the ZnO (n⁺) film and the CIGS thin film (p⁻) does not reach the sidewall (surface exposed by etching) of the patterned CIGS thin film (p⁻), whereby an embedded structure of the P-N junction interface is implemented.

The numbers of crystal defects and damages on the side surface of the CIGS thin film (p⁻) patterned by photolithography are sufficiently small as compared with the case of mechanical scribing. However, dangling bonds and the like are still present and it cannot be said that no unnecessary energy levels are formed. Therefore, a leakage current from the end of the interface of the P-N junction can be further reduced by preventing the end of the P-N junction interface from reaching the side surface (surface exposed by etching) of this patterned CIGS thin film (p⁻).

Finally, an extraction electrode is formed (step S6). Thus, a photoelectric conversion device is completed.

The method for producing a photoelectric converter according to the present invention is now specifically described with reference to FIGS. 2(a) to 2(j).

FIGS. 2 (a) to 2 (j) are sectional views of the device along the respective principal steps for specifically illustrating the method for producing a photoelectric converter according to the present invention.

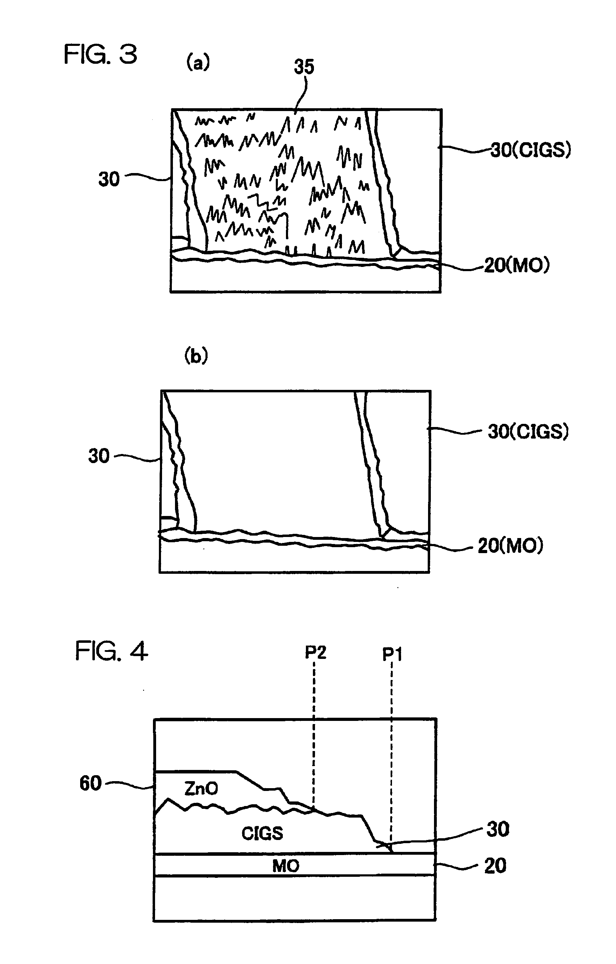

In the following description, FIGS. 3(a), 3(b) and 4 are referred to. FIG. 3 shows diagrams schematically showing SEM (scanning electron microscope) photographs of the device enlarged to 10,000 magnifications for illustrating a method of patterning the CIGS thin film: (a) shows a state immediately after dry etching of the CIGS thin film; and (b) shows a state after wet etching.

FIG. 4 is a diagram schematically showing a SEM (scanning electron microscope) sectional photograph (photograph enlarged to 20,000 magnifications) of the device after patterning of the light transmitting electrode layer (ZnO film).

First, a Mo (molybdenum) film is formed on a soda-lime glass substrate (SLG) 10 by sputtering with a thickness of 0.6 µm, as shown in FIG. 2(a).

As shown in FIG. 2(b), a CIGS thin film 30 is formed in a composition of Cu:In:Ga:Se = 1:0.5:0.5:2, for example, with a thickness of 1.7 µm.

Referring to FIG. 2(c), the CIGS thin film 30 is dry-etched using a resist pattern 40. In other words, the CIGS thin film 30 is vertically etched and patterned with a chlorine gas and a bromine gas employed as etchants. While etching hardly causing side etching can be performed at a high rate in this case, a large number of residues 35 remain (as seen from FIG. 3(a), a large number of columnar residues remain on a large number of Mo films).

Therefore, the residues 35 are completely removed by performing treatment with a mixed solution of bromine and methanol or a mixed solution of water and ammonia, and thereafter performing treatment with a mixed solution of hydrochloric acid and nitric acid, as shown in FIG. 2(d). As shown in FIG. 3(b), the residues 35 are completely removed.

Thus, the CIGS thin film 30 constituting a photoabsorption layer can be precisely etched at a high rate without causing an undercut by employing the chlorine gas and the bromine gas as the etchants for dry etching. Thereafter short-time wet etching is performed for completely removing the columnar residues 35. Thus, the CIGS thin film can be precisely patterned without causing residues. In this case, neither damages nor defects are caused in the crystals of the CIGS thin film 30 unlike a case of employing mechanical etching, and the dark current can be remarkably reduced.

Then, the resist pattern 40 is removed. FIG. 2(e) shows the section of the device in this state.

As shown in FIG. 2(f), a thin CdS film 50 (about 50 nm) is formed by solution growth as a buffer layer (window layer), and a ZnO film 60 is subsequently formed by sputtering.

The ZnO film 60 is formed by continuously forming a non-doped ZnO film (i-ZnO) and a low-resistance ZnO (n⁺) film (denoted as n-ZnO in the Figure) doped with an n-type impurity. The thickness of the i-ZnO film is about 60 nm, and the thickness of the low-resistance ZnO (n⁺) film is about 1 µm.

The non-doped ZnO film (i-ZnO) functions to fill up voids and pinholes formed in the underlayer CIGS thin film with a semi-insulating layer and form an i-p junction with the CIGS thin film 30, thereby preventing a leakage resulting from a tunnel current.

Therefore, the dark current on the P-N junction interface can be reduced by increasing the thickness of the non-doped ZnO film (i-ZnO). However, since the increased thickness is sufficiently small (60 nm, for example), a substantial p-n junction is conceivably formed between the low-resistance ZnO (n⁺) film functioning as the light transmitting electrode layer and the CIGS thin film (p⁻).

Then, a resist pattern 70 is formed and the ZnO film (i-ZnOand ZnO (n⁺)) 30 is thereafter wet-etched, as shown in FIG. 2(g).

In other words, wet etching is performed with a dilute acid of hydrochloric acid:water = 1:10, for example. At this time, the etching time is adjusted for intentionally causing side etching and forming an undercut under the resist pattern 70. This is intended that such the position of an end of the patterned ZnO film 60 is inward beyond the side surface of the patterned CIGS thin film (p⁻) 60.

Then, dry etching is performed using the resist pattern 70 for partially removing the CdS film 50 on the sidewall of the CIGS thin film 30. FIG. 2(h) shows the sectional structure of the device in this state.

Then, the resist pattern 70 is removed, as shown in FIG. 2(i). As shown in FIG. 2(i), the lateral width W2 of the ZnO film 60 is smaller than the lateral width W1 of the CIGS thin film (p⁻) 30, whereby a pyramidal structure is formed. As clearly understood from FIG. 4, the position P2 of the end of the ZnO film 60 is located inward beyond the position P1 of the sidewall of the CIGS thin film 30.

Consequently, an end of an interface 80 (boundary between depletion layers: shown by a dotted line in FIG. 2(i)) of the P-N junction formed by the ZnO (n⁺) film 60 and the CIGS thin film (p⁻) 30 does not reach the sidewall (surface exposed by etching) of the patterned CIGS thin film (p⁻) 30, whereby an embedded structure of the P-N junction interface is implemented.

The numbers of crystal defects and damages on the sidewall (surface exposed by etching) of the CIGS (p⁻) thin film patterned by photolithography are sufficiently small as compared with the case of mechanical scribing. However, dangling bonds or the like could be still present and it cannot be said that no unnecessary energy levels are formed.

Therefore, the leakage current from the end of the interface of the P-N junction can be further reduced by preventing the end of the P-N junction interface 80 from reaching the sidewall of this patterned CIGS (p⁻) thin film 30.

Finally, extraction electrodes 90 and 95 made of aluminum or the like are formed, as shown in FIG. 2(j). Thus, the photoelectric converter is completed.

This photoelectric converter can be used as a high-efficiency solar battery as such.

### (Embodiment 2)

In this embodiment, an example of using the photoelectric converter according to the present invention as a photosensor having a high sensitivity also in the near infrared region is described.

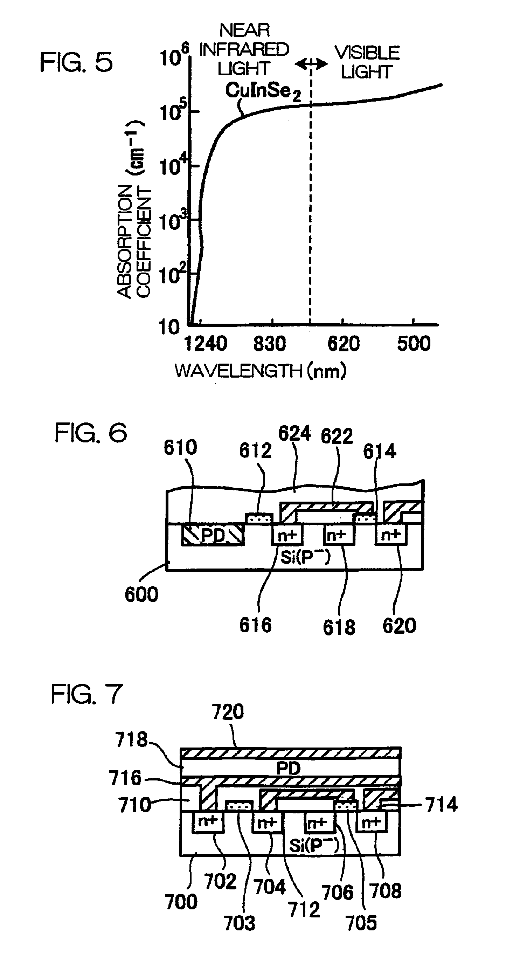

FIG. 5 is a diagram showing absorption coefficients of a CIS thin film (also applies to a CIGS thin film) with respect to the wavelengths of light. As is illustrated, it is understood that the CIS film (CIGS thin film) has a high sensitivity over a wide range from visible light to near infrared light.

With attention drawn to this point, a composite image sensor is formed by laminating the photoelectric converter of the present invention made of a compound semiconductor thin film on a silicon substrate formed with a CMOS circuit in this embodiment.

FIG. 6 is a schematic sectional view of a general CMOS image sensor formed on a silicon substrate. FIG. 7 is a schematic sectional view of the composite image sensor according to the present invention formed by laminating the photoelectric converter (photosensor) made of a compound semiconductor thin film on the silicon substrate provided with the CMOS circuit according to the embodiment of the present invention.

In the general CMOS image sensor, a photodiode 610 (having a p-i-n structure, for example) and n⁺ diffusion layers 616, 618 and 620 constituting MOS transistors are formed in a P⁻-type silicon substrate 600, while gate layers 612 and 614 of the MOS transistors, a wiring layer 622 and a protective film (including an interlayer dielectric film) 624 are formed on the P⁻-type silicon substrate 600, as shown in FIG. 6.

In the composite image sensor according to the present invention, on the other hand, n⁺ diffusion layers 702, 704, 706 and 708 constituting MOS-transistors are formed in a P⁻-type silicon substrate 700, while gate layers 703 and 705 of the MOS transistors, wiring layers 712 and 714 and an interlayer dielectric film 710 are formed on the P⁻-type silicon substrate 700.

The photoelectric converter (photosensor) made of a compound semiconductor thin film is laminated and formed on this interlayer dielectric film 710.

This photoelectric converter (photosensor) is made of a lower wiring layer 716, a CIGS thin film (PD) 718 (an electrode layer is omitted in the Figure) functioning as a photoabsorption layer and an upper wiring layer 720.

As described with reference to the above-mentioned embodiment, the CIGS thin film according to the present invention is precisely patterned without residues by dry and wet two-stage etching employing photolithography, and the numbers of damages to the crystals and crystal defects are reduced. Further, the end of the P-N junction interface is embedded by photolithographic patterning of the ZnO film not to reach the etched sidewall of the CIGS thin film, and the dark current is dramatically reduced by about five orders of magnitude as compared with the conventional device.

The sensor according to the present invention has a high sensitivity also for near infrared light, whereby the same is sufficiently utilizable as a security camera (camera sensing visible light by day and sensing near infrared light by night), a personal identification camera (camera for personal identification with near infrared light not influenced by external light) or an onboard camera (camera loaded on a vehicle for nightly visual aid or distant visual field assurance).

While Cu(Inₓ, Ga₍₁₋ₓ₎)Se₂ is employed as the compound semiconductor thin film (CIGS thin film) having the chalcopyrite structure in the above-mentioned embodiment, the present invention is not limited thereto.

A film having a composition of Cu(Inₓ,Ga₍₁₋ₓ₎)) (Se_{y}, S_{(1-y)}))₂, x = 0 to 1, y = 0 to 1 is also known as the CIGS thin film, and a CIGS thin film having this composition is also utilizable.

This CIGS thin film can be formed on a substrate by vacuum evaporation or sputtering. When vacuum evaporation is employed, the respective components (Cu, In, Ga, Se and S) of the compound are separately evaporated on the substrate as evaporation sources. In sputtering, the chalcopyrite compound is employed as a target, or the respective components thereof are separately employed as targets. When the chalcopyrite compound semiconductor thin film is formed on a metal substrate or a glass substrate, the substrate is heated to a high temperature, whereby re-evaporation results from heating of the chalcogenide elements (Se and S). Therefore, compositional deviation may be caused by desorption of the chalcogenide elements. In this case, Se or S is preferably replenished by performing heat treatment in a vapor atmosphere of Se or S at a temperature of 400 to 600°C for about 1 to several hours after the film formation (selenidation or sulfuration).

According to the present invention, as hereinabove described, the light transmitting electrode layer is patterned by photolithographic etching in place of mechanical scribing, and the lower electrode layer and the compound semiconductor thin film with the chalcopyrite structure functioning as the photoabsorption layer are also patterned by photolithographic etching. Therefore, neither damages nor defects are caused in the compound semiconductor thin film unlike the case of performing mechanical scribing, and the dark current can be remarkably reduced.

Further, the light transmitting electrode layer is patterned such that the position of the end thereof is inward beyond the side surface of the compound semiconductor thin film to prevent the end of the P-N junction interface from not reaching the side surface of the patterned compound semiconductor thin film (in other words, the P-N junction interface is embedded in the compound semiconductor thin film). Therefore, the leakage current from the end of the interface of the P-N junction can be further reduced.

Further, the recombination process of carriers can be reduced by using the CIGS thin film prepared by substituting gallium for part of In (indium) to widen the bandwidth. Accordingly, the dark current can be further reduced.

In addition, the non-doped ZnO film (i-ZnO) is provided as the light transmitting electrode layer for filling up voids and pinholes formed in the underlayer CIGS thin film with the semi-insulating layer and forming the i-p junction with the CIGS thin film. Thus, a leakage resulting from a tunnel current caused when the conductive ZnO film (n⁺) is directly brought into contact with the CIGS thin film can be prevented. Therefore, the dark current on the P-N junction interface can be further reduced (can be reduced to about 1/5) by increasing the thickness of non-doped ZnO film (i-ZnO).

The photoelectric converter according to the present invention is patterned by photolithography and neither damages nor defects are caused in the crystals of the compound semiconductor dissimilarly to the case of employingmechanical scribing. Therefore, no unnecessary energy levels are formed on the interface of the P-N junction, and the dark current can be reduced.

Further, the leakage current from the end of the P-N junction interface can also be prevented by innovating the pattern of the ZnO film and embedding the P-N junction interface. In other words, the dark current can be improved on the order of 10³ by changing the production process and optimizing the device structures of the photoabsorption layer and the light transmitting electrode layer.

Further, the dark current can be reduced on the order of 10² by band gap control in Cu(Inₓ,Ga(₁₋ₓ₎)Se₂.

The sensor according to the present invention has high a sensitivity also for near infrared light, whereby the same is sufficiently utilizable as a security camera (camera sensing visible light by day and sensing near infrared light by night), a personal identification camera (camera for personal identification with near infrared light not influenced by external light) or an onboard camera (camera loaded on a vehicle for nightly visual aid or distant visual field assurance).

In the photoelectric conversion according to the present invention, photoelectric conversion loss on the interface of the P-N junction is sufficiently reduced as compared with the prior art. Therefore, a solar battery having a high collection efficiency for charges generated by light and high photoelectric conversion efficiency can be implemented.

While the present invention has been described in detail by way of the embodiments thereof, it should be understood that these embodiments are merely illustrative of the technical principles of the present invention but not limitative of the invention. The spirit and scope of the present invention are to be limited only by the appended claims.

This application corresponds to Japanese Patent Application No. 2005-316788 filed with the Japanese Patent Office on October 31, 2005, the disclosure of which is incorporated herein by reference in its entirety.

### INDUSTRIAL AVAILABILITY

The present invention exhibits the effect of remarkably reducing the dark current of a photoelectric conversion element employing a compound semiconductor thin film. Therefore, the present invention is effective as a photosensor suitable for a security camera or a personal identification camera, a solid-state image sensor and a solar battery, and a method for producing these photoelectric converters.

## Claims

1. A photoelectric converter comprising a lower electrode layer on a substrate, a compound semiconductor thin film with a chalcopyrite structure functioning as a photoabsorption layer and a light transmitting electrode layer that are sequentially laminated, wherein
a pattern of the light transmitting electrode layer is formed that an end of the compound semiconductor thin film with the chalcopyrite structure is positioned outward beyond an end of the light transmitting electrode layer.

2. The photoelectric converter according to Claim 1, wherein
a plurality of photoelectric conversion element cells are integrated.

3. The photoelectric converter according to Claim 1, wherein
a plurality of photoelectric conversion element cells are integrated, and the compound semiconductor thin film with the chalcopyrite structure is integrally formed on the surface of the substrate.

4. The photoelectric converter according to Claim 1, wherein
a plurality of photoelectric conversion elements are integrated, and the compound semiconductor thin film with the chalcopyrite structure is formed that a pattern edge thereof is positioned outward beyond a pattern edge of the light transmitting electrode.

5. The photoelectric converter according to Claim 4, wherein
the compound semiconductor thin film is arranged that a pattern width thereof is larger than the pattern of the light transmitting electrode.

6. The photoelectric converter according to Claim 1, wherein
the compound semiconductor thin film with the chalcopyrite structure is Cu(Inₓ, Ga₍₁₋ₓ₎)Se₂ (0 ≦ x ≦ 1).

7. The photoelectric converter according to Claim 1, wherein
the light transmitting electrode layer is configured with a non-doped ZnO film provided on an interface between the light transmitting electrode layer and the compound semiconductor thin film and an n⁺-type ZnO film provided on the non-doped ZnO film.

8. The photoelectric converter according to Claim 1, wherein
the photoelectric converter is a photosensor having a sensitivity also in a near infrared region.

9. The photoelectric converter according to Claim 1, wherein
the photoelectric converter is a solar battery.

10. A method for producing a photoelectric converter configured by sequentially laminating a lower electrode layer, a compound semiconductor thin film with a chalcopyrite structure functioning as a photoabsorption layer and a light transmitting electrode layer on a substrate, the method comprising the step of:
selectively removing and patterning the light transmitting electrode with respect to the compound semiconductor thin film with the chalcopyrite structure to expose a part of the compound semiconductor thin film with the chalcopyrite structure.

11. The method for producing a photoelectric converter according to Claim 10, wherein
the step of patterning the light transmitting electrode layer is the step of patterning so as to position an end of the light transmitting electrode layer inward beyond a side surface of the compound semiconductor thin film such that an end of a P-N junction interface configured by contact between the light transmitting electrode layer and the compound semiconductor thin film does not reach the side surface of the compound semiconductor thin film.

12. The method for producing a photoelectric converter according to Claim 11, wherein
the step of forming the compound semiconductor thin film with the chalcopyrite structure includes the step of forming a Cu(Inₓ,Ga₍₁₋ₓ₎)Se₂ (0 ≦ x ≦ 1) thin film by PVD, and
the step of forming the light transmitting electrode layer includes the steps of forming a non-doped ZnO film on the compound semiconductor thin film and forming an n⁺-type ZnO film on the non-doped ZnO film.
